# EUROPEAN PATENT APPLICATION

(11) **EP 4 773 797 A1**
(43) Date of publication of application: **08.07.2026**
(21) Application number: 25218435.3
(22) Date of filing: 25.11.2025
(51) Int. Cl.: H10W 70/60, H10W 70/685, H10W 90/10, H10W 90/00

(54) **HANGING DIE-TO-DIE INTERCONNECT BRIDGE FOR INTERPOSER PACKAGES**

(30) Priority: 06.01.2025 US 202519011343
(71) Applicant: INTEL Corporation, Santa Clara, CA 95054 (US)
(72) Inventor: WAIDHAS, Bernd, 93186 Pettendorf (DE); LANGENBUCH, Michael, 81825 München (DE); BAUMGARTNER, Peter, 81929 München (DE); Stahl, Joachim, 92714 Pleystein (DE); SCHIML, Thomas, 82008 Unterhaching (DE); PALANISAMY, Sidharthi, 82024 Taufkirchen (DE); MILOSEVIC, Marko, 81671 München (DE)
(74) Representative: 2SPL Patentanwälte PartG mbB

(57) **Abstract**

Bridge die interposer packages, and related apparatuses, systems, and techniques are discussed. An interposer package includes a bridge die having a routing structure to interconnect multiple integrated circuit (IC) dies of the package. Power is provided to the IC dies by a mesh power supply metallization and a mesh ground metallization that extend from outside a perimeter of the bridge die to within the perimeter and over the routing structure. The bridge die may be absent through silicon vias (TSVs) and may be hanging such that it is exposed at the bottom of the package.

## Description

### BACKGROUND

Higher performance, lower cost, increased miniaturization, greater packaging density, and increased product flexibility of integrated circuit (IC) devices are ongoing goals of the electronics industry. IC packaging is a stage of semiconductor or IC device fabrication in which one or more IC dies that have been monolithically fabricated are assembled into a package that protects the IC dies from physical damage, and communicatively connects the IC dies to other packaged IC dies and/or a scaled host component, such as a package substrate, or a printed circuit board.

Multiple IC dies can be co-assembled, for example, into a multi-die package. Some package architectures include IC dies coupled to a passive bridge die having a routing layer and through silicon vias (TSVs) that extend through the bridge die. For example, the high-density routing capability of silicon wafer technology can be leveraged to provide die-to-die interconnections using the passive bridge die in bridge die interposer packages. In such architectures, power supply of the top IC dies is provided by the TSVs that extend through the bridge die and vertically connect the interposer bottom side package level interconnects to the top side interconnects to the top IC dies.

However, such architectures have difficulties including cost, reliability, and process complexity issues related to fabricating and embedding the bridge die having TSVs. It is with respect to these and other considerations that the present improvements have been needed. Such improvements may become critical as the desire to deploy high-performance IC packages in various devices and systems becomes more widespread.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements. In the figures:
FIG. 1 is an illustration of a cross-sectional side view of a portion of an example hanging bridge die interposer structure;
FIG. 2 is an illustration of a cross-sectional side view of the portion of the hanging bridge die interposer structure of FIG. 1 showing power supply, ground, and signal routing within the hanging bridge die interposer structure;
FIG. 3 is an illustration of a cross-sectional side view of the portion of the hanging bridge die interposer structure of FIG. 1 to show exemplary cross-sectional top-down views of the hanging bridge die interposer structure;
FIG. 4 is an illustration of a cross-sectional top-down view of a portion of a mesh metallization layer of a power supply routing in the hanging bridge die interposer structure of FIG. 1;
FIG. 5 is an illustration of a cross-sectional top-down view of a portion of a mesh metallization layer of a ground routing in the hanging bridge die interposer structure of FIG. 1;
FIG. 6 is an illustration of a cross-sectional side view of an entirety of the hanging bridge die interposer structure of FIG. 1 to show an exemplary top-down view of the hanging bridge die interposer structure;
FIG. 7 is an illustration of a top-down view of an example layout of a hanging bridge die interposer structure including multiple IC dies overlying multiple bridge dies;
FIG. 8 is a flow diagram illustrating example methods for fabricating and assembling hanging bridge die interposer structures;
FIGS. 9, 10, 11, 12, 13, 14, 15, and 16 are illustrations of cross-sectional side views of hanging bridge die interposer structures as the methods of FIG. 8 are practiced to form the hanging bridge die interposer structure of FIG. 1;
FIG. 17 is an illustration of a cross-sectional side view of package structures as the methods of FIG. 8 are practiced to assemble a package assembly having a hanging bridge die interposer;
FIG. 18 illustrates exemplary systems employing an IC assembly including a hanging bridge die interposer structure; and
FIG. 19 is a block diagram of a computing device, all arranged in accordance with at least some implementations of the present disclosure.

### DETAILED DESCRIPTION

One or more embodiments or implementations are now described with reference to the enclosed figures. While specific configurations and arrangements are discussed, it should be understood that this is done for illustrative purposes only. Persons skilled in the relevant art will recognize that other configurations and arrangements may be employed without departing from the spirit and scope of the description. It will be apparent to those skilled in the relevant art that techniques and/or arrangements described herein may also be employed in a variety of other systems and applications other than what is described herein.

Reference is made in the following detailed description to the accompanying drawings, which form a part hereof, wherein like numerals may designate like parts throughout to indicate corresponding or analogous elements. It will be appreciated that for simplicity and/or clarity of illustration, elements illustrated in the figures have not necessarily been drawn to scale. For example, the dimensions of some of the elements may be exaggerated relative to other elements for clarity. Further, it is to be understood that other embodiments may be utilized, and structural and/or logical changes may be made without departing from the scope of claimed subject matter. It should also be noted that directions and references, for example, up, down, top, bottom, over, under, and so on, may be used to facilitate the discussion of the drawings and embodiments and are not intended to restrict the application of claimed subject matter. Therefore, the following detailed description is not to be taken in a limiting sense and the scope of claimed subject matter defined by the appended claims and their equivalents.

In the following description, numerous details are set forth. However, it will be apparent to one skilled in the art, that the present invention may be practiced without these specific details. In some instances, well-known methods and devices are shown in block diagram form, rather than in detail, to avoid obscuring the present invention. Reference throughout this specification to "an embodiment" or "one embodiment" means that a particular feature, structure, function, or characteristic described in connection with the embodiment is included in at least one embodiment of the invention. Thus, the appearances of the phrase "in an embodiment" or "in one embodiment" in various places throughout this specification are not necessarily referring to the same embodiment of the invention. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description of the invention and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items. Herein, the term "predominantly" indicates not less than 50% of a particular material or component while the term "substantially pure" indicates not less than 99% of the particular material or component and the term "pure" indicates not less than 99.9% of the particular material or component. Unless otherwise indicated, such material percentages are based on atomic percentage. Herein the term concentration is used interchangeably with material percentage and also indicates atomic percentage unless otherwise indicated.

The terms "coupled" and "connected," along with their derivatives, may be used herein to describe structural relationships between components. It should be understood that these terms are not intended as synonyms for each other. Rather, in particular embodiments, "connected" may be used to indicate that two or more elements are in direct physical or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause an effect relationship).

The terms "over," "under," "between," "on", and/or the like, as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact with that second layer. Similarly, unless explicitly stated otherwise, one feature disposed between two features may be in direct contact with the adjacent features or may have one or more intervening features. The term immediately adjacent indicates such features are in direction contact. Furthermore, the terms "substantially," "close," "approximately," "near," and "about," generally refer to being within +/- 10% of a target value. The term layer as used herein may include a single material or multiple materials. As used in throughout this description, and in the claims, a list of items joined by the term "at least one of" or "one or more of" can mean any combination of the listed terms. For example, the phrase "at least one of A, B or C" can mean A; B; C; A and B; A and C; B and C; or A, B and C.

Apparatuses, systems, and methods are described herein related to interconnect bridge packages including a bridge die having a routing structure to interconnect multiple integrated circuit (IC) dies of the package. Power is provided to the IC dies by a mesh power supply metallization and a mesh ground metallization that extend from outside a perimeter of the bridge die to within the perimeter and over the routing structure. The bridge die may be absent through silicon vias (TSVs) and may be hanging such that it is exposed at the bottom of the package.

As described above, current package architectures may include multiple IC dies coupled to a passive bridge die having a routing layer adjacent the IC dies and through TSVs that extend through the bridge die to provide power to the IC dies. For example, power and ground may be provided from package level interconnects below the bridge die vertically through the TSVs of the bridge die to the overlying IC dies. However, such architectures require fabrication of TSVs in the bridge die as well as assembly processes that embed the bridge die in the package. These processes are complicated, costly, and prone to yield loss and other issues.

In some embodiments, a package architecture includes a bridge die having a routing structure to interconnect two or more IC dies of the package on a monolithic substrate of the bridge die. As used herein, the term monolithic indicates a component of a single material or compound. Notably, the passive bridge die is absent TSVs. The routing structure on the monolithic substrate is used to conduct signals between IC dies of the multiple IC die package. A bridge die has and defines a perimeter that at least a portion of IC dies the bridge die interconnects extends into. Power is delivered to die level interconnects of the IC dies within the perimeter of the bridge die using a power supply metallization mesh and a ground metallization mesh. Notably, the die level interconnects extend vertically from the bottoms of the IC dies within the perimeter to contact the metallization meshes. Each of the power supply metallization mesh and the ground metallization mesh extend from outside of the perimeter to within the perimeter to provide power supply and ground. Each of the power supply metallization mesh and a ground metallization mesh are contacted by package level interconnects outside of the perimeter of the bridge die and feed the die level interconnects within the perimeter by via structures that contact the pertinent mesh metallization. Other via structures extend through the mesh metallization and are surrounded by dielectric material that isolates them from the mesh metallization. As used herein, the term mesh metallization or continuous mesh metallization are used substantially interchangeably and indicate a continuous metal layer that is interrupted by vias that are not to couple to the metallization and extend through the metallization surrounded by an insulating dielectric. The mesh metallization may include some holes (e.g., of any shape) to support dielectric outgassing and/or manage manufacturing metal layer density for metal plating homogeneity or warpage management due to, for example, different thermal expansion of the materials used in the interposer or redistribution structure. As used herein, the term power is meant generally to indicate a power supply or a ground of a power network. The term power supply indicates a supply voltage of a power network, and the term ground indicates a ground of a power network. Therefore, the term power is used as an umbrella term inclusive of either of a power supply or a ground. The terms signal or IO, and similar terms, indicate input/output, data signaling, or the like.

For example, interposer package structures discussed herein provide power to a die-to-die physical interface without TSVs in the bridge die of the interposer package. Notably, current bridge die interposer packages may require two redistribution layers for IO routing of the top IC dies to the package level interconnect (e.g., C4 bumps), with the routing density requirement in the redistribution layers being relatively low (e.g. 5 µm lines/5 µm space), which allows relatively thick redistribution layer metallization of, for example, about 4 µm. Currently, within the perimeter of the bridge die area, the redistribution layers are used for stacked vias from the bridge die to the top dies with the stacked vias being used for signal or power. Embodiments herein dedicate the stacked vias for signal and use the area between these stacked vias to build a power mesh (e.g., one layer for power supply (VDD) and one layer for ground (VSS)). These relatively thick power mesh layers are supplied by package level interconnects (e.g., C4 bumps) that are laterally adjacent to the bridge die edge and outside the perimeter of the bridge die. The discussed embodiments have a variety of advantages including process simplification, yield improvement, and cost reduction due to, for example, not needing to fabricate TSVs in the bridge die and not needing to embed the bridge die.

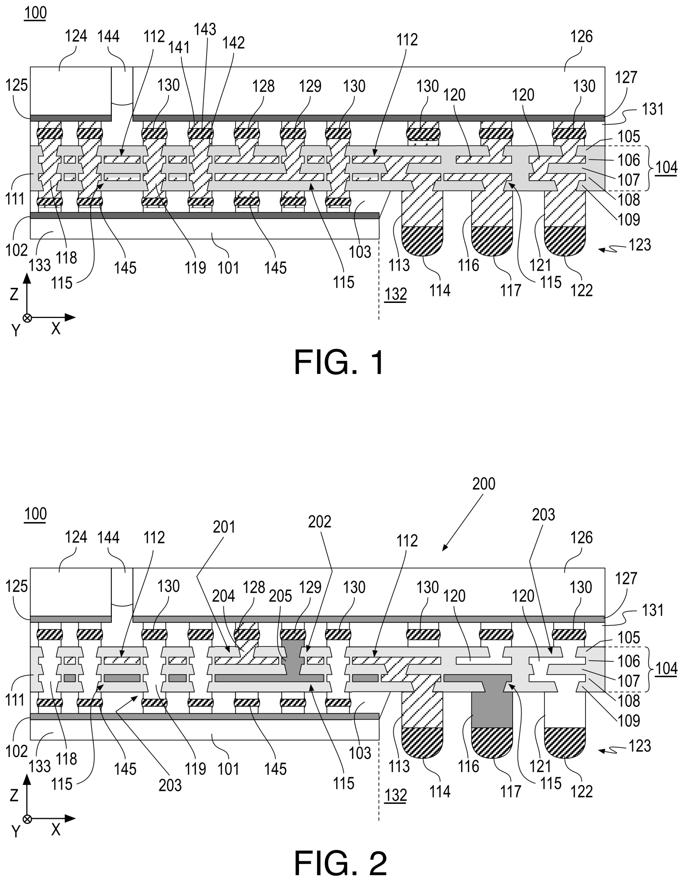

FIG. 1 is an illustration of a cross-sectional side view of a portion of an example hanging bridge die interposer structure 100, arranged in accordance with at least some implementations of the present disclosure. As shown, a redistribution structure 104 (or redistribution layers) is between active IC dies 124, 126 and a bridge die 101, and includes a number of metallization layers 105, 106, 107, 108, 109 embedded within dielectric layers 111. In FIG. 1, dielectric layers 111 are illustrated as a single dielectric for the sake of clarity of presentation. However, it is understood dielectric layers 111 may be discrete layers built-up with metallization layers 105, 106, 107, 108, 109 in the z-dimension.

Each of metallization layers 105, 106, 107, 108, 109 are fabricated to a particular thickness and have a particular pattern or architecture. In the context of hanging bridge die interposer structure 100, metallization layers 105, 107, 109 are via layers that typically include vias (e.g., circular vias, oblong vias, or vias of other shapes) that extend through the corresponding dielectric layers 111, and metallization layers 106, 108 include mesh metallization layers 112, 115, respectively, that are embedded in dielectric layers 111. For example, metallization layers 106, 108 may include mesh metallization layers 112, 115 and other patterns, while metallization layers 105, 107, 109 typically include via structures for interconnecting metallization layers 106, 108. In some embodiments, redistribution structure 104 of hanging bridge die interposer structure 100 may be advantageously fabricated upon a glass carrier for improved flatness and/or thickness control, as discussed herein below.

As shown, hanging bridge die interposer structure 100 includes any number of active IC dies such as IC dies 124, 126 over redistribution structure 104. Herein the term active IC die indicates an integrated device having active integrated device structures such as transistors. The term passive die indicates a structure that may provide routing but does not have active devices, as with passive bridge die 101. As shown, active IC dies 124, 126 include routing structures 125, 127, respectively, that may be die level metallization layers that interconnect the devices of IC dies 124, 126, provide power to the devices of active IC dies 124, 126, and allow the devices of IC dies 124, 126 to communicate with each other and outside devices (i.e., devices to which hanging bridge die interposer structure 100 will be coupled) using die level interconnects 128, 129, 130, as well as package level interconnects 123. As discussed further herein below, die level interconnects 128 may be power supply interconnects, die level interconnects 129 may be ground interconnects, and die level interconnects 130 may be signal interconnects. In some embodiments, IC dies 124, 126 each include a device layer (e.g., a layer of transistors formed within the substrate of IC dies 124, 126) immediately adjacent to routing structures 125, 127. Although illustrated with respect to single level IC dies 124, 126, each of IC dies 124, 126 may be or may be replaced by a die stack of multiple IC dies. Such architectures may be deployed in high bandwidth memory (HBM) applications, for example. Routing structures 125, 127 may include any suitable structures such as any number of metallization line layers interconnected by via layers, as is known in the art. As shown, an underfill material 131 may embed die level interconnects 128, 129, 130 under IC dies 124, 126, and a mold material 144 may be provided between IC dies 124, 126.

Bridge die 101 is under a portion of redistribution structure 104 with redistribution structure 104 being vertically between at least portions of bridge die 101 and portions of IC dies 124, 126. Bridge die 101 is coupled to redistribution structure 104 using bridge interconnects 145. As shown, bridge interconnects 145 and die level interconnects 128, 129, 130 may include one or more metallization features for interconnections such as a die side pad 141, a redistribution layer side pad 142, and an intervening solder feature 143 (e.g., a flip chip connection). However, any bonding structures such as hybrid bonding features may be used. An underfill material 103 may embed bridge interconnects 145 under bridge die.

Bridge die 101 includes routing structure 102 on a monolithic substrate 133 of bridge die 101. Routing structure 102 includes die level metallization layers (e.g., fabricated on a wafer and diced to form bridge die 101) that provide for interconnection between IC dies 124, 126 and optional communication to outside devices. As discussed further herein below, bridge interconnects 145 are signal interconnects and are absent power interconnects since power supply and ground are provided using mesh metallization layers 112, 115. Monolithic substrate 133 is absent any through TSVs and any dedicated device layer. Monolithic substrate 133 may include any suitable material. In some embodiments, monolithic substrate 133 includes a Group IV material (e.g., silicon). In some embodiments, monolithic substrate 133 includes a substantially monocrystalline material. In some embodiments, monolithic substrate 133 is non-monocrystalline material such as glass. In some embodiments, bridge die 101 is predominantly silicon and oxygen, such as at least 23 percent silicon and at least 26 percent oxygen, by weight (i.e., wt. %). Bridge die 101 may further include one or more additives, such as, aluminum, boron, magnesium, calcium, barium, tin, sodium, potassium, strontium, phosphorus, zirconium, lithium, titanium, or zinc. In some embodiments, bridge die 101 is rectangular in shape in plan view. However, other shapes may be used. Bridge die 101 has and defines a perimeter 132 such that perimeter 132 is at an outer edge of bridge die 101. The term perimeter is used in its ordinary meaning to indicate the outer boundary of bridge die 101, which is typically a geometric figure such as a rectangle, and the perimeter extends vertically such that an object or component may cross the perimeter above or below bridge die 101.

As shown, via structures 118, 119 extend vertically (i.e., along the z-axis) from bridge die 101 to one of IC dies 124, 126. Notably, via structures 118, 119 are not coupled to other portions of metallization layers 106, 108 and are therefore not coupled to mesh metallization layers 112, 115. As discussed below, via structures 118, 119 may be used for signal routing. For example, a signal route may be established between IC dies 124, 126 using die level interconnects 130, via structures 118, 119, bridge interconnects 145, and routing structure 102.

Mesh metallization layers 112, 115 provide power to IC dies 124, 126 such that mesh metallization layer 112 provides one of a power supply or a ground and mesh metallization layer 115 provides the other. In the following, mesh metallization layers 112, 115 are illustrated with mesh metallization layer 112 providing the power supply and mesh metallization layer 115 providing ground, but they may be reversed. Notably, mesh metallization layer 112 is coupled (through metallization layers 106, 107, 108, 109) to a metallization structure including a metal post 113 and a metal interconnect feature 114. Metal post 113 may be characterized as a vertical metal interconnect or pillar or the like and may be or include copper. Metal interconnect feature 114 may be characterized as a bump or ball or the like and may be a solder material. Although illustrated with metal post 113 and metal interconnect feature 114, the metallization structures of package level interconnects 123 may include any suitable interconnects.

In a similar manner, mesh metallization layer 115 is coupled (through metallization layer 109) to a metallization structure including a metal post 116 and a metal interconnect feature 117, and other die level interconnects 130 are coupled (through metallization layers 105, 106, 107, 108, 109) to a metallization structure including a metal post 121 and a metal interconnect feature 122. Thereby, some of package level interconnects 123 provide signal routing and others provide power supply and ground routing.

In the context of hanging bridge die interposer structure 100, the power supply and ground ones of package level interconnects 123 are outside of perimeter 132 of bridge die 101 and the metallization structure of package level interconnects 123 are laterally adjacent to routing structure 102 and monolithic substrate 133. In the illustrated example, metal posts 113, 116, 121 are laterally adjacent (i.e., both have portions in a same x-y plane) to routing structure 102, metal posts 113, 116, 121 are laterally adjacent to a portion of monolithic substrate 133, and metal interconnect features 114, 117, 122 are laterally adjacent to another portion of monolithic substrate 133. However any suitable structures may be implemented such that package level interconnects 123 are laterally adjacent to routing structure 102 and laterally adjacent to monolithic substrate 133.

Furthermore, due to power (supply and ground) being routed from package level interconnects 123 up to redistribution structure 104, laterally through mesh metallization layers 112, 115, and then up to IC dies 124, 126, package level interconnects 123 are not deployed under bridge die 101. This allows for TSVs to be omitted from bridge die 101, and for there to be no need to embed bridge die 101 in mold material or other dielectric material. Thereby, bridge die 101 may be defined as a hanging bridge die as it is not fully embedded or surrounded by other materials or components of hanging bridge die interposer structure 100. Furthermore, no routing structures or interconnect structures are provided on the surface of monolithic substrate 133 opposite routing structure 102.

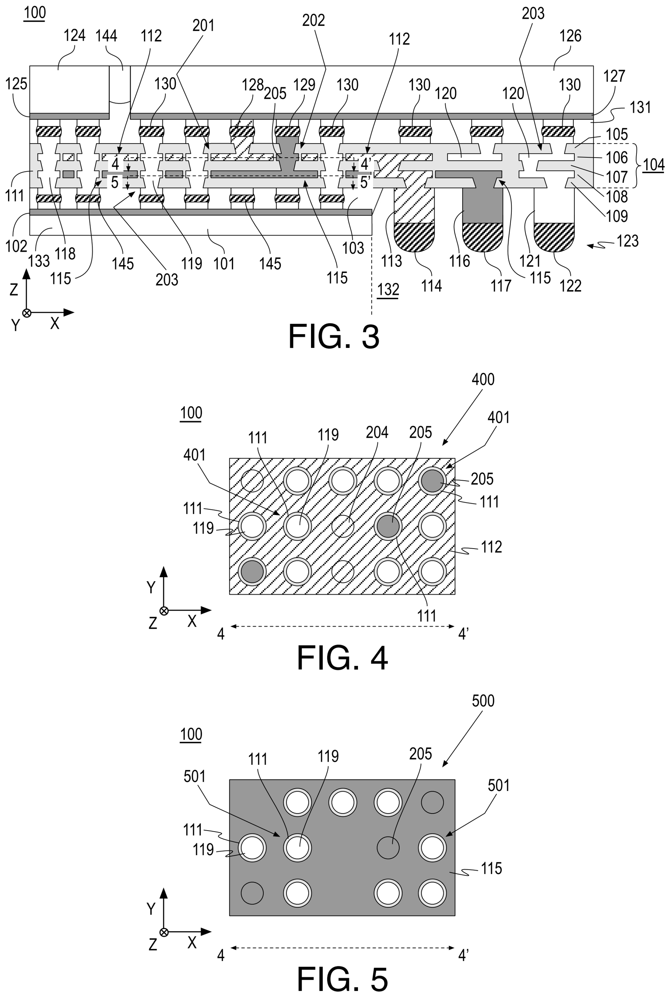

As shown, redistribution structure 104 and each of mesh metallization layers 112, 115 are over bridge die 101 and extend across perimeter 132 of bridge die 101. As illustrated further herein below with respect to FIGS. 4 and 5, each of mesh metallization layers 112, 115 is or includes a continuous mesh metallization that is a substantially planar metal structure interrupted by vias that extend vertically through the metal structure. For example, via structures 118, 119 (is signal vias) extend vertically through each of mesh metallization layers 112, 115 within perimeter 132 with each of via structures 118, 119 surrounded by dielectric layers 111, which is in contact with via structures 118, 119 and mesh metallization layers 112, 115. As also shown, metallization layers 106, 108 may be further used to routing 120 outside of mesh metallization layers 112, 115 such that metallization layers 106, 108 may include mesh metallization layers 112, 115 and other metallization of hanging bridge die interposer structure 100.

FIG. 2 is an illustration of a cross-sectional side view of the portion of hanging bridge die interposer structure 100 showing power supply, ground, and signal routing 200 within hanging bridge die interposer structure 100, arranged in accordance with at least some implementations of the present disclosure. In FIG. 2, exemplary power supply routing 201 is shown with cross hatching, exemplary ground routing 202 is shown with a dark fill, and exemplary signal routing 203 is shown with a white fill. For example, FIG. 2 differs from FIG. 1 in that it illustrates exemplary power supply, ground, and signal routing 200 routing.

As shown with respect to power supply routing 201, in some embodiments, power is provided to IC dies 124, 126 via a route that brings in the power supply through metal interconnect feature 114 and metal post 113 (e.g., from an outside host structure), which are one metallization structure of any number of package level interconnects 123. The power supply of power supply routing 201 is then routed through metallization layer 109 (e.g., a via of metallization layer 109), metallization layer 108 (e.g., a trace or plane of metallization layer 108), and metallization layer 107 (e.g., a via of metallization layer 107) to mesh metallization layer 112. As discussed, mesh metallization layer 112 extends laterally along metallization layer 106 from outside of perimeter 132 to within perimeter 132. That is, mesh metallization layer 112 brings power from outside of perimeter 132 to within perimeter 132 for delivery to IC dies 124, 126. As shown, a via structure 204 of power supply routing 201 and of metallization layer 105 contacts mesh metallization layer 112 within perimeter 132, and brings power to die level interconnect 128, which may be characterized as a power supply interconnect, for delivery to IC die 126. Similar routing within metallization layer 105 and die level interconnects 128 may deliver power supply to IC die 124 within perimeter 132.

Ground connectivity is provided to IC dies 124, 126 via ground routing 202. Ground routing 202 includes metal interconnect feature 117 and metal post 116, which are one metallization structure of package level interconnects 123. Ground routing 202 then extends through metallization layer 109 (e.g., a via of metallization layer 109) to mesh metallization layer 115. Mesh metallization layer 115 extends laterally along metallization layer 108 from outside of perimeter 132 to within perimeter 132 such that mesh metallization layer 115 provides ground connectivity from outside of perimeter 132 to within perimeter 132 for IC dies 124, 126. As shown, a via structure 205 of ground routing 202 and inclusive of metallizations from of metallization layers 105, 106, 107 contacts mesh metallization layer 115 within perimeter 132, and provides a ground for die level interconnect 129, which may be characterized as a ground interconnect. As with power supply routing 201, similar routing within metallization layers 105, 106, 107 and die level interconnects 129 may provide a ground for IC die 124 within perimeter 132.

Lastly, a variety of signal routings 203 are provided by metallization layers 105, 106, 107, 108, 109. For example, via structures 118, 119, which extend vertical from bridge die 101 to one of IC dies 124, 126 provide signal routings 203 from routing structure 102 between bridge interconnects 145 and die level interconnects 130, which may be characterized as signal interconnects. Furthermore, signal routings 203 may be provided between die level interconnects 130 to metal post 121 and metal interconnect feature 122, which are one metallization structure of any number of package level interconnects 123. Such signal routings 203 extend through metallization layers 105, 106, 107, 108, 109. In some embodiments, one or more of such signal routings 203 are entirely outside of perimeter 132.

In the illustrated embodiment, mesh metallization layer 112 is a power supply mesh metallization that is over mesh metallization layer 115, which is a ground mesh metallization. In other embodiments, the ground mesh metallization is over the power supply mesh metallization. Furthermore, in the illustrated embodiment, only two substantially planar metallization layers 108, 109 are provided in redistribution structure 104. In other embodiments, additional planar metallization layers are deployed. In some embodiments, one or more planar metallization layers are between mesh metallization layers 112, 115 in redistribution structure 104. In some embodiments, one or more planar metallization layers are above or below mesh metallization layers 112, 115 in redistribution structure 104.

FIG. 3 is an illustration of a cross-sectional side view of a portion of hanging bridge die interposer structure 100 to show exemplary cross-sectional top-down views 4-4' and 5-5' of hanging bridge die interposer structure 100 taken at mesh metallization layers 112, 115, arranged in accordance with at least some implementations of the present disclosure. In FIG. 3 to 5, exemplary power supply routing 201, exemplary ground routing 202, and exemplary signal routing 203 are also illustrated with cross hatching, dark fill, and white fill, respectively, for the sake of clarity of presentation. Cross-sections 4-4' and 5-5' taken at mesh metallization layers 112, 115 provide lateral cross-sections to illustrate the continuous mesh of mesh metallization layers 112, 115 as well as interconnection to mesh metallization layers 112, 115 within hanging bridge die interposer structure 100.

FIG. 4 is an illustration of a cross-sectional top-down view of a portion 400 of mesh metallization layer 112 of power supply routing 201 in hanging bridge die interposer structure 100, arranged in accordance with at least some implementations of the present disclosure. As shown in FIG. 4, mesh metallization layer 112 may, in some parts, be substantially continuous other than through via regions 401, which occur at any location where a metallization feature is to pass through mesh metallization layer 112 (i.e., metallization layer 106) without contacting mesh metallization layer 112. In some embodiments, mesh metallization layer 112 may further include some holes (e.g., of any shape) to support dielectric outgassing and/or manage manufacturing metal layer density for metal plating homogeneity or warpage management due to, for example, different thermal expansion of the materials used in the interposer or redistribution structure. Furthermore, redistribution structure 104 may include more than one power supply and/or ground mesh metallization within metallization layers 106, 108. For example, hanging bridge die interposer structure 100 may require more than one power supply mesh network. In such contexts, metallization layer 106 and/or metallization layer 108 may include more than one power supply or ground mesh metallization network. As shown, at each of through via regions 401, the pertinent via structure extends through mesh metallization layer 112 and is isolated from mesh metallization layer 112 by a portion of dielectric layers 111 (e.g., a dielectric material).

For example, via structures 119 (refer to FIG. 3), which carry signal routing 203, extend through mesh metallization layer 112 and are isolated from mesh metallization layer 112 by dielectric layer 111. Similarly, via structures 205 (refer to FIG. 3), which provide ground routing 203, extend through mesh metallization layer 112 and are isolated from mesh metallization layer 112 by dielectric layer 111. Furthermore, via structures 204 (refer to FIG. 3) of the same routing type as mesh metallization layer 112, which in this example provide power supply routing 201, land on mesh metallization layer 112 as illustrated with an outline in FIG. 4. For example, the metallization structure of metallization layer 105 of via structure 204 lands on mesh metallization layer 112.

As also illustrated in FIG. 4, mesh metallization layer 112 is a continuous mesh metallization that is a substantially planar metal structure interrupted by vias or via regions 401 that extend vertically through the mesh metallization layer 112 to interrupt the planar metal structure. Via structures 119, 205 may have any suitable cross-sectional width (e.g., diameter) in the x-y plane such as a cross-sectional width in the range of about 5 to 25 µm. Via structures 119, 205 may have any suitable pitch such as a hexagonal pitch of not more than 50 µm. Mesh metallization layer 112 may have any suitable thickness (in the z-dimension) such as a thickness of about 4 µm, which provide for efficient power supply for IC dies 124, 126.

FIG. 5 is an illustration of a cross-sectional top-down view of a portion 500 of mesh metallization layer 115 of ground routing 202 in hanging bridge die interposer structure 100, arranged in accordance with at least some implementations of the present disclosure. As shown in FIG. 5, mesh metallization layer 115 is also continuous outside of through via regions 501, which again occur at any location where a metallization feature is to pass through mesh metallization layer 115 (i.e., metallization layer 108) without contacting mesh metallization layer 115. For example, at each of through via regions 501, the pertinent via structure extends through mesh metallization layer 115 and is isolated from mesh metallization layer 115 by the dielectric material of a portion of dielectric layers 111.

For example, via structures 119 (refer to FIG. 3), which carry signal routing 203, also extend through mesh metallization layer 115 and are isolated therefrom by dielectric layer 111. In the context of the present embodiment, no power supply vias extends through mesh metallization layer 115; however, as discussed, the power supply/ground orientation of mesh metallization layers 112, 115 may be reversed. In such contexts, power supply vias extend through mesh metallization layer 115 and are isolated from mesh metallization layer 115 by the dielectric material of dielectric layer 111. Via structures 205 (refer to FIG. 3) of the same routing type as mesh metallization layer 115, which in this example provide ground routing 202, land on mesh metallization layer 115 as illustrated with an outline in FIG. 5. For example, the metallization structure of metallization layer 107 of via structure 205 lands on mesh metallization layer 115.

As with mesh metallization layer 112, mesh metallization layer 115 is a continuous mesh metallization that is a substantially planar metal structure interrupted by vias or via regions 401 that extend vertically through the mesh metallization layer 115 to interrupt the planar metal structure. Via structures 119 may have any suitable cross-sectional width and pitch as discussed above. Mesh metallization layer 115 may have any suitable thickness (in the z-dimension) such as a thickness of about 4 µm. In the context of FIGS. 4 and 5, via structures 119, 204, 205 have circular cross-sectional shapes and the surrounding dielectric material of dielectric layer 111 has the same circular cross-sectional shape. However, via structures 119, 204, 205 and the surrounding dielectric material of dielectric layer 111 may have any cross-sectional shape such as squares, hexagonal, or octagonal. As shown, the surrounding dielectric material may have a shape that conforms to the shape of via structures 119, 204, 205. The difference between the cross-sectional widths (e.g., diameters or other widths depending on shape) of via structures 119, 204, 205 and the surrounding dielectric layers 111 may be any suitable distance such as a distance of about 5 µm, a distance in the range of 2 µm to 7µm, a distance in the range of 1 to 2 µm, or the like. In some embodiments, via structures 119, 204, 205 and/or the surrounding dielectric material have a different cross-sectional shape such as ovular, square, or rectangular.

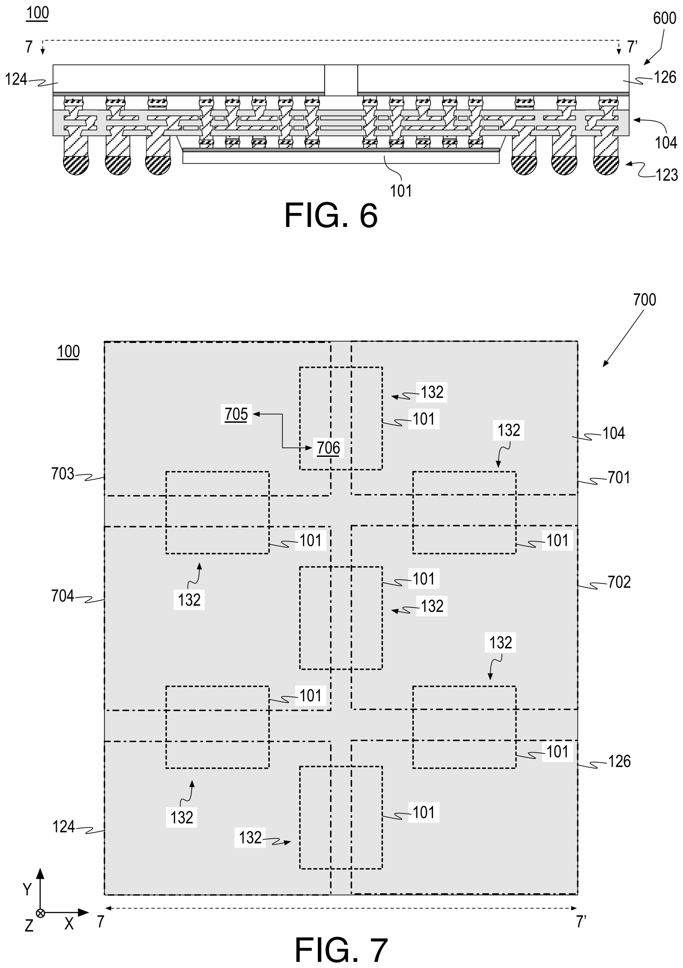

FIG. 6 is an illustration of a cross-sectional side view of an entirety 600 of hanging bridge die interposer structure 100 to show an exemplary top-down view 7-7' of hanging bridge die interposer structure 100 taken over IC dies 124, 126, arranged in accordance with at least some implementations of the present disclosure. In the context of FIG. 6, each feature is not labeled and exemplary routing shading is not shown for the sake of clarity of presentation. Top-down view 7-7' provides a view that illustrates the multi-die context and lateral power delivery of hanging bridge die interposer structure 100.

FIG. 7 is an illustration of a top-down view of an example layout 700 of hanging bridge die interposer structure 100 including multiple IC dies overlying multiple bridge dies 101, arranged in accordance with at least some implementations of the present disclosure. Hanging bridge die interposer structure 100 may include any number of IC dies 124, 126, 701, 702, 703, 704 in any suitable layer(s). In the context of layout 700, each of IC dies 124, 126, 701, 702, 703, 704 has a portion within perimeter 132 and a portion outside of perimeter 132 of each of two or three bridge dies 101. However, other layouts are available. As shown, redistribution structure 104 (as well as each of mesh metallization layers 112, 115) extends from outside 705 to inside 706 of perimeter 132 of each of bridge die 101 to bring power supply and to provide a ground from outside 705 to inside 706 of perimeter 132 to those portions of IC dies 124, 126, 701, 702, 703, 704 within perimeter 132 of one or more of bridge dies 101, as discussed above.

Thereby, hanging bridge die interposer structure 100 includes any number of bridge dies 101 each having monolithic substrate 133 and routing structure 102 on a surface of monolithic substrate 133. Hanging bridge die interposer structure 100 further includes redistribution structure 104 over each bridge die 101 (i.e., inside 706 of perimeters 132) and extending beyond perimeter 132 (i.e., outside 705 of perimeters 132) of bridge dies 101. Redistribution structure 104 has metallization layers 106, 108, which include continuous mesh metallization layers 112, 115 to provide power supply and ground, as discussed above. Any number of via structures 118, 119 provide signal routing and extend through metallization layers 106, 108 within perimeters 132, such that via structures 118, 119 are each surrounded by dielectric layer 111, which is in contact with via structures 118, 119 and in contact with mesh metallization layers 112, 115. One, some, or all of bridge dies 101 are absent any TSVs, and routing structures 102 interconnect via structures 118, 119 within perimeter 132 to provide signal routing.

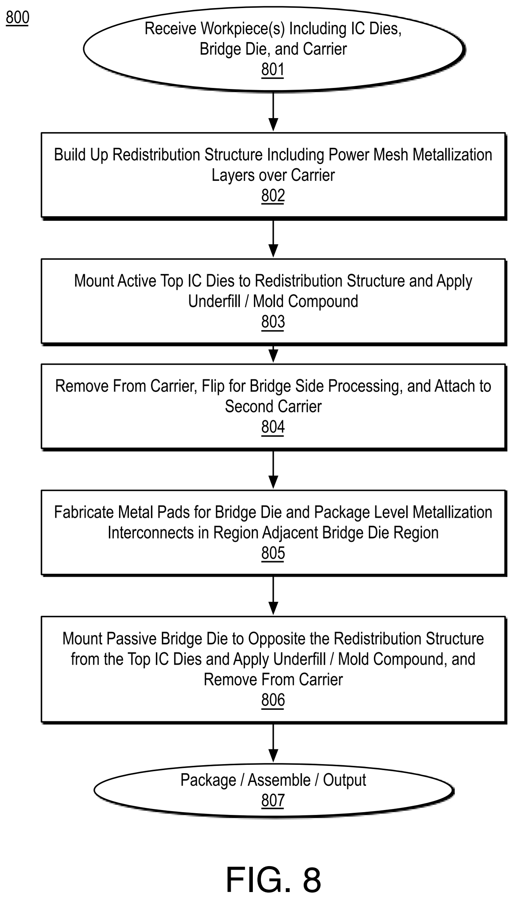

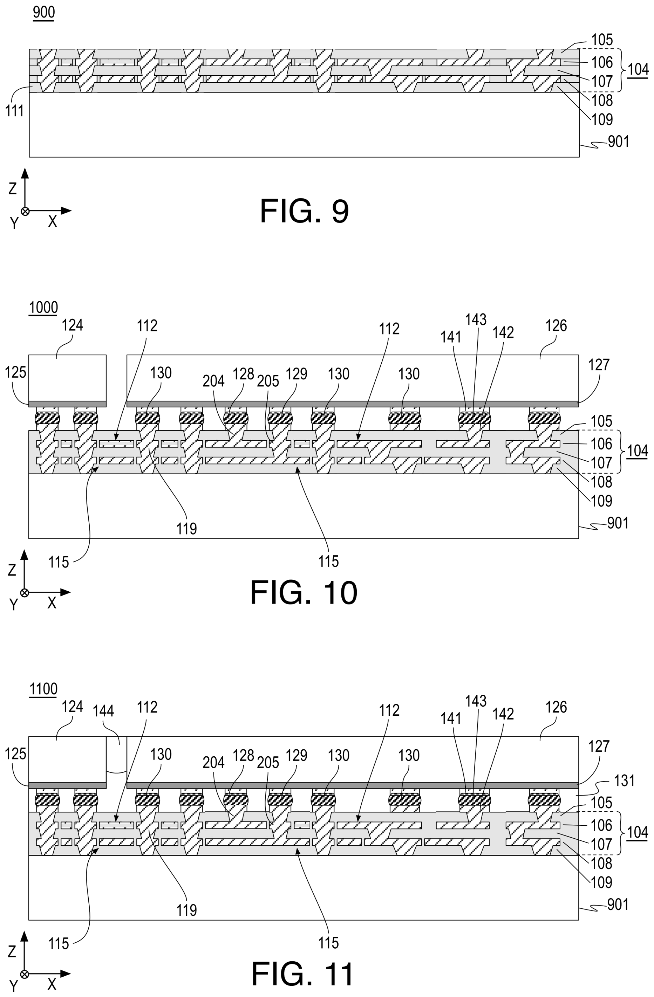

FIG. 8 is a flow diagram illustrating example methods 800 for fabricating and assembling hanging bridge die interposer structures, arranged in accordance with at least some implementations of the present disclosure. For example, methods 800 may be implemented to fabricate any hanging bridge die interposer structures, package structures, or assemblies discussed herein. In the illustrated embodiment, methods 800 include one or more operations as illustrated by operations 801-807. However, embodiments herein may include additional operations, certain operations being omitted, or operations being performed out of the order provided. FIGS. 9-17 illustrate structures and components as methods 800 are practiced.

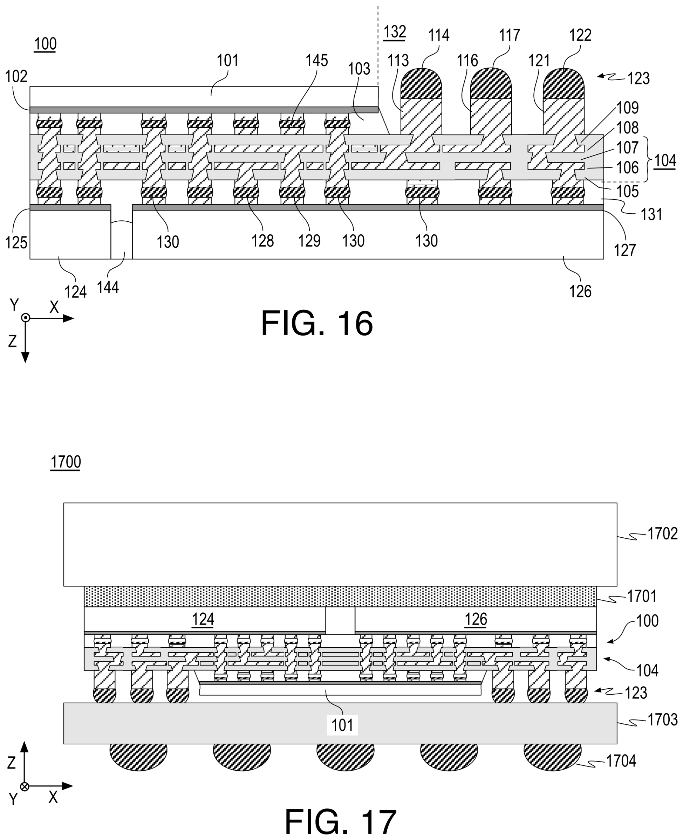

FIGS. 9, 10, 11, 12, 13, 14, 15, and 16 are illustrations of cross-sectional side views of hanging bridge die interposer structures as methods 800 are practiced to form hanging bridge die interposer structure 100, arranged in accordance with at least some implementations of the present disclosure. FIG. 17 is an illustration of a cross-sectional side view of package structures as methods 800 are practiced to assemble a package assembly having a hanging bridge die interposer, arranged in accordance with at least some implementations of the present disclosure.

Methods 800 begins at operation 801, where workpieces such as fabricated and diced IC dies, fabricated and diced bridge dies, a glass carrier are received. The workpieces may be prepared upstream of methods 800, for example. Notably, the IC dies are to be assembled into a package structure and include routing structures to couple to a built-up redistribution structure. Similarly, the bridge die is fabricated with a routing structure to couple to the built-up redistribution structure, but the bridge die is absent TSVs and the surface opposite the surface having the routing structure may be absent any routing structure, interconnects, etc. The glass carrier may be in a large panel format, a wafer format, or the like.

Processing continues at operation 802, where an electrical redistribution structure is built up or formed over one side of the glass carrier received at operation 801 in preparation for assembly with a bridge die and multiple IC dies. The fabricated redistribution structure, which may also be characterized as an electrical routing structure, may have any characteristics discussed with respect to redistribution structure 104. The redistribution structure includes multiple levels of metallization features embedded within any suitable dielectric material. The redistribution structure formed at operation 802 will interconnect the IC dies, the bridge die, and deliver power from outside of the perimeter of the bridge die to the IC dies. Accordingly, the metallization feature pitches, and thicknesses of the metallization layers of the routing structure are advantageously selected for interconnect density and power delivery.

FIG. 9 is an illustration of a cross-sectional side view of hanging bridge die interposer structure 900 including a carrier 901 such as a glass carrier, and redistribution structure 104 built-up over carrier 901. Carrier 901 may be any suitable material such as glass in any format such a large panel format or a wafer format and having any thickness to support subsequent fabrication operations. Redistribution structure 104 may have any features, characteristics, etc. discussed herein above. Redistribution structure 104 may be built-up over carrier 901 using any suitable technique or techniques. In some embodiments, a first layer of dielectric layers 111 is applied to carrier 901 using any suitable application such as lamination techniques, slit-coating techniques, spin-on techniques, etc. The first layer may then be patterned to form openings corresponding to the features of metallization layer 109. The second layer of dielectric layers 111 may then be applied and patterned. Metallization layers 109, 108 are then formed by fabricating a metal in the openings using, for example, plating techniques. Such techniques are then repeated for each layer of dielectric layers 111 and metallization layer 107, 106, and so on. The materials of each layer of dielectric layers 111 may be the same or they may be different. Similarly, the materials of each of metallization layers 105, 106, 107, 108, 109 (or combinations of commonly applied metallization layers) may be the same or they may be different.

The material(s) of each of metallization layers 105, 106, 107, 108, 109 may be any suitable conductive material(s) such as copper formed within a liner material such as titanium nitride. Dielectric layers 111 may be any suitable insulating material or materials such as a molding compound, a spin-on material, or a dry film laminate material. In some embodiments, dielectric layers 111 are applied in a wet or uncured state into a cast and are then dried or cured. Alternatively, dielectric layers 111 may be applied as a semi-cured dry film that is fully cured following its application. The composition of dielectric layers 111 may include one or more of an organic dielectric material, such as, polyimide materials, epoxy resins, phenolic-glasses, or resinous films such as the GX-series films commercially available from Ajinomoto Fine-Techno Co., Inc. (ABF). Exemplary epoxy resins for deployment in dielectric layers 111 include an acrylate of novolac such as epoxy phenol novolacs (EPN) or epoxy cresol novolacs (ECN). Other material systems may be used.

As discussed, redistribution structure 104 may have any characteristics discussed above and metallization layers 105, 106, 107, 108, 109 include mesh metallization layers 112, 115 for deployment in a package architecture. In some embodiments, metallization layers 106, 108 each have a thickness (i.e., in the z-dimension) of not less than 4 µm to support power delivery as discussed herein. In some embodiments, metallization layers 106, 108 each have a thickness of not less than 4 µm and not more than 20 µm. In some embodiments, metallization layers 106, 108 each have a thickness of not less than 6 µm and not more than 12 µm. In some embodiments, metallization layers 106, 108 each have a thickness of not less than 10 µm. Other thicknesses may be used depending on use case.

Returning to FIG. 8, methods 800 continue at operation 803, where multiple active IC dies are mounted to the redistribution structure fabricated at operation 802. Each of the IC dies assembled at operation 803 include active electrical circuitry. In some embodiments, one or more of the IC dies include logic circuitry including logic gates. The one or more IC dies assembled at operation 803 may also include any photonic circuitry suitable for the detection, emission or processing (e.g., filtering, multiplexing and demultiplexing) of optical signals. Any number of IC dies may be mounted to the redistribution structure, such as four, five, six, or more. The IC dies may have any suitable active circuitry such as logic circuitry, memory circuitry, integrated electric and photonics devices, etc. for any suitable application. Furthermore, at operation 803 an optional underfill and/or mold compound may be applied to embed the interconnects formed between the IC dies and the redistribution structure, to provide mechanical support, and protection from the environment for the assembled components.

FIG. 10 is an illustration of a cross-sectional side view of a hanging bridge die interposer structure 1000 similar to hanging bridge die interposer structure 900, after mounting any number of IC dies such as IC dies 124, 126 to redistribution structure 104. IC dies 124, 126 may be mounted to redistribution structure 104 using any suitable technique or techniques such as flip chip connection mounting, as shown, which may form die side pad 141, redistribution layer side pad 142, and intervening solder feature 143. However, any bonding structures such as hybrid bonding features may be used. As shown in FIG. 10, die level interconnect 128 is coupled to via structure 119, die level interconnect 128 is coupled to mesh metallization layer 112 through via structure 204, and die level interconnect 129 is coupled to mesh metallization layer 115 through via structure 205.

FIG. 11 is an illustration of a cross-sectional side view of a hanging bridge die interposer structure 1100 similar to hanging bridge die interposer structure 1000, after application of underfill material 131 and mold material 144. Underfill material 131 and mold material 144 embed die level interconnects 128, 129, 130 and provide mechanical support and protection from the environment. Underfill material 131 may include any suitable material such as an epoxy-based resin or acrylate-based resin and may be applied using any suitable technique or techniques such as liquid application using capillary application, followed by a cure. Mold material 144 may also be epoxy-based resin or acrylate-based resin and may be applied any suitable technique or techniques such as liquid dispense followed by a cure and optional overburden removal. In some embodiments, material is removed from the backsides of IC dies 124, 126 using, for example, grinding operations to bring a later applied heat sink, heat spreader, or other heat removal solution closer to the device layers adjacent routing structures 125, 127.

Returning to FIG. 8, methods 800 continue at operation 804, where the carrier is removed from the workpiece to expose the surface of the redistribution structure opposite the assembled IC dies. The IC die side may be characterized as an active side, a top IC die side, or the like. The carrier may be removed using any suitable technique or techniques such as heating and pealing, UV release, or the like. The workpiece is then flipped to expose the surface of the redistribution structure opposite the assembled IC dies for fabrication of package level interconnects and mounting a pre-fabricated bridge die. For example, the IC die side may be mounted to a chuck or other work surface for subsequent operations. As discussed, the released carrier provided a high-quality flat surface for fabrication of the redistribution structure.

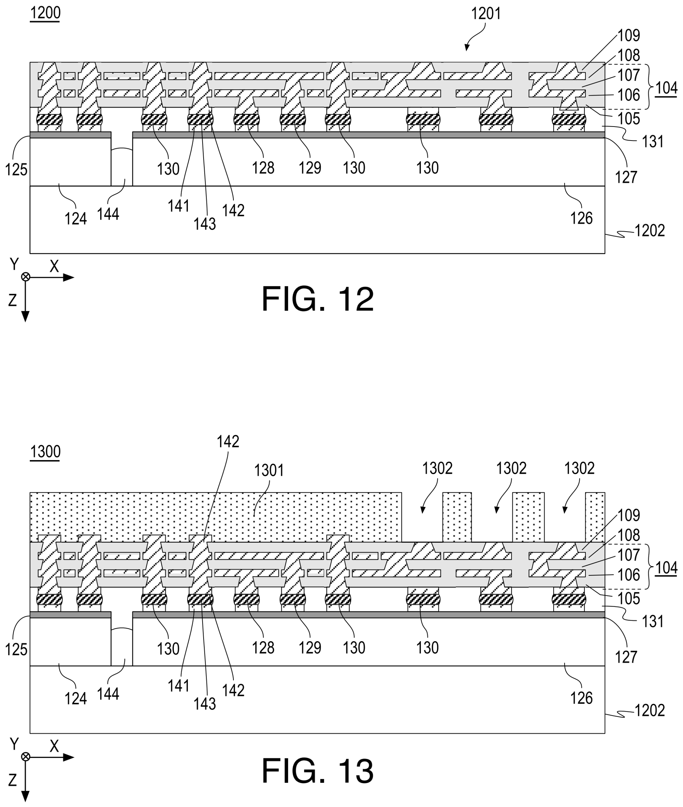

FIG. 12 is an illustration of a cross-sectional side view of a hanging bridge die interposer structure 1200 similar to hanging bridge die interposer structure 1100, after removal of carrier 901 to expose surface 1201 of redistribution structure 104 and flipping the workpiece in preparation for fabrication of package level interconnects and mounting a pre-fabricated bridge die. As discussed, carrier 901 may be removed by heating and pealing, UV release, or similar processing. The workpiece is also flipped (refer to FIG. 11) and may be mounted to a carrier 1202, which may have any characteristics as discussed with respect to carrier 901.

Returning to FIG. 8, methods 800 continue at operation 805, where metal pads for bridge die attachment are fabricated in the bride die region, and package level interconnects are fabricated adjacent a region dedicated to a bridge die such that the package level interconnects are outside of a dedicated perimeter of the bridge die. The metal pads for bride die attachment may be fabricated using any suitable technique or techniques such as lithography and metal deposition techniques. The package level interconnects may then be fabricated using any suitable technique or techniques. In some embodiments, a resist layer such as a dry resist layer is patterned over the exposed surface of the redistribution structure such that openings in the resist layer define metallization features such as metal posts of the package level interconnects. The metallization features may then be formed using any suitable technique or techniques such as plating techniques followed by planarization techniques to remove any overburden. For example, the metal posts of the package level interconnects may be copper. Metal interconnect features of the package level interconnects may then be formed on the metal posts using any suitable technique or techniques such as application of solder features to the metal posts. For example, the metal interconnect features of the package level interconnects may be solder balls, bumps, or the like.

FIG. 13 is an illustration of a cross-sectional side view of a hanging bridge die interposer structure 1300 similar to hanging bridge die interposer structure 1200, after formation of redistribution layer side pads 142 and after formation of patterned layer 1301. Redistribution layer side pads 142 may be formed using lithography and metal deposition techniques, followed by removal of the lithography pattern, for example. Patterned layer 1301 may be formed using any suitable technique or techniques such as bulk deposition of a resist material, exposure to light, and selective removal of portions of the bulk material to define openings 1302 of patterned layer 1301. As discussed, openings 1302 define the features of metal posts of package level interconnects, and openings 1302 are outside of perimeter 132. In some embodiments, patterned layer 1301 is then removed and the solder of

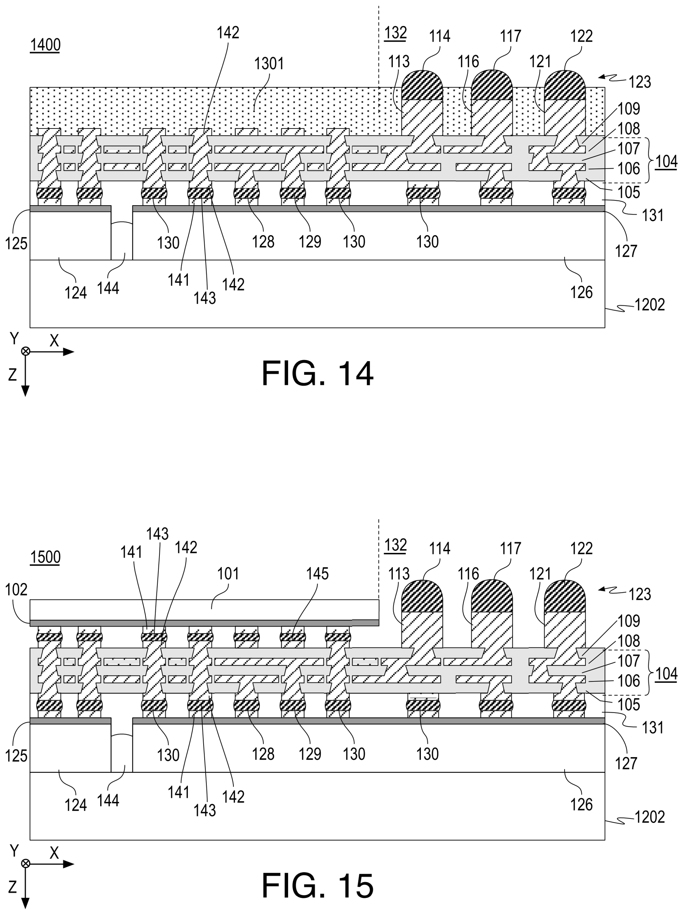

FIG. 14 is an illustration of a cross-sectional side view of a hanging bridge die interposer structure 1400 similar to hanging bridge die interposer structure 1300, after fabrication of package level interconnects 123. Package level interconnects 123 may be formed using any suitable technique or techniques. In some embodiments, metal posts 113, 116, 121 are first formed using plating techniques followed by planarization techniques to remove any overburden. Metal interconnect features 114, 117, 122 may then be formed on metal posts 113, 116, 121 by deposition of a solder material. For example, metal posts 113, 116, 121 may be copper and metal interconnect features 114, 117, 122 may be a solder material. In some embodiments, patterned layer 1301 is then removed and the solder of interconnect features 114, 117, 122 is reflowed, as is known in the art.

Returning to FIG. 8, methods 800 continue at operation 806, where a passive bridge die having a prefabricated routing structure is mounted to the redistribution structure on a surface opposite the mounting of IC dies discussed at operation 803. As discussed, the bridge die is passive such that it is absent active components. Furthermore, the bridge die is absent TSVs and the surface opposite the prefabricated routing structure is absent any routing features, metallization, etc. The bridge die may be mounted usings any suitable technique or techniques such as flip chip connection mounting. Furthermore, an underfill may be applied to embed the interconnects formed between the passive bridge die and the redistribution structure, and the workpiece may be removed from the carrier.

FIG. 15 is an illustration of a cross-sectional side view of a hanging bridge die interposer structure 1500 similar to hanging bridge die interposer structure 1400, after mounting bridge die 101 to redistribution structure 104 within and defining perimeter 132. Bridge die 101 may be mounted to redistribution structure 104 using any suitable technique or techniques such as flip chip connection mounting, as shown, which may form die side pad 141, redistribution layer side pad 142, and intervening solder feature 143 of . However, any bonding structures such as hybrid bonding features may be used.

FIG. 16 is an illustration of a cross-sectional side view of a hanging bridge die interposer structure 100 similar to hanging bridge die interposer structure 1500, after application of underfill material 103. Underfill material 103 embeds bridge interconnects 145 and provides mechanical support and protection for hanging bridge die interposer structure 100. Underfill material 103 may include any suitable material and may be applied using any suitable technique or techniques discussed with respect to underfill material 131. Carrier 1202 may then be removed by heating and pealing, UV release, or similar processing. Hanging bridge die interposer structure 100 may have any features or characteristics discussed herein, and hanging bridge die interposer structure 100 may be deployed in any suitable computing device or system.

Returning to FIG. 8, methods 800 continue at operation 807, where a final device is packaged, assembled, and output, for example, by attachment of a hanging bridge die interposer structure to a host component, and other assembly processing. The assembly or package may be installed in any suitable electronic device such as a laptop, a netbook, a notebook, an ultrabook, a smartphone, a tablet, a personal digital assistant PDA, an ultra-mobile PC, a mobile phone, a desktop computer, a server, a printer, a scanner, a monitor, a set-top box, an entertainment control unit, a digital camera, a portable music player, a digital video recorder, or the like.

FIG. 17 is an illustration of a cross-sectional side view of a package structure 1700 similar to hanging bridge die interposer structure 100 after attachment to a host component 1703 and deployment of one or more heat spreaders and/or heat sinks 1702. As shown, package structure 1700, which may be characterized as a system, includes hanging bridge die interposer structure 100 attached to host component 1703 with package level interconnects 123. In some embodiments, package level interconnects 123 include solder (e.g., SAC) microbumps (i.e., metal interconnect features 114, 117, 122 are a solder material) although, as discussed, other interconnect features may be used. In some embodiments, host component 1703 is or includes one or more materials known to be suitable as package substrates (e.g., an epoxy preform, cored or coreless laminate board, etc.). In some embodiments, host component 1703 is a printed circuit board (PCB). In some embodiments, host component 1703 includes one or more metallized redistribution levels (not depicted) embedded within a dielectric material. Host component 1703 may also include one or more IC dies, one or more passive or active components, or the like embedded therein.

Host component 1703 may include interconnects 1704 which may include solder (e.g., ball, bump, etc.) suitable for a given host board architecture (e.g., surface mount FR4, etc.). Also as shown, one or more heat spreaders and/or heat sinks 1702 may be coupled to hanging bridge die interposer structure 100, which may be advantageous, for example, where IC dies 124, 126 include one or more CPU cores or other circuitry of similar power density. Any thermal interface material 1701 may couple IC dies 124, 126 to heat spreader/sink 1702. Although not illustrated, IC dies 124, 126 may be grinded down prior to application of thermal interface material 1701 such that heat spreader/sink 1702 may closer to a device layer of IC dies 124, 126.

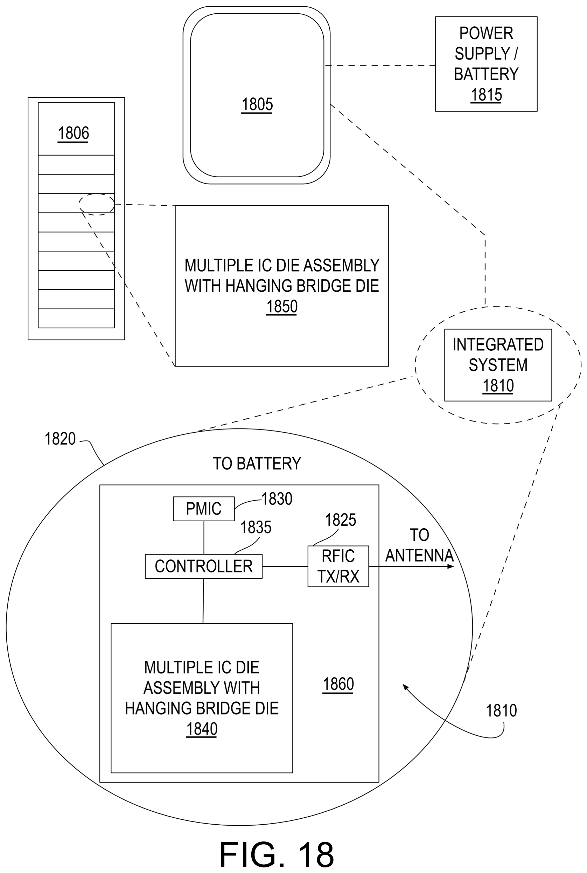

FIG. 18 illustrates exemplary systems employing an IC assembly including a hanging bridge die interposer structure, arranged in accordance with at least some implementations of the present disclosure. The system may be a mobile computing platform 1805 and/or a data server machine 1806, for example. Either may employ a component assembly including an IC assembly including a hanging bridge die interposer structure as described elsewhere herein. Server machine 1806 may be any commercial server, for example including any number of high-performance computing platforms disposed within a rack and networked together for electronic data processing, which in the exemplary embodiment includes an IC die assembly 1850 with a hanging bridge die interposer structure as described elsewhere herein. Mobile computing platform 1805 may be any portable device configured for each of electronic data display, electronic data processing, wireless electronic data transmission, or the like. For example, mobile computing platform 1805 may be any of a tablet, a smart phone, a laptop computer, etc., and may include a display screen (e.g., a capacitive, inductive, resistive, or optical touchscreen), a chip-level or package-level integrated system 1810, and a battery 1815 and/or power supply circuitry. Although illustrated with respect to mobile computing platform 1805, in other examples, chip-level or package-level integrated system 1810 and battery 1815 may be implemented in a desktop computing platform, an automotive computing platform, an internet of things platform, or the like. As discussed below, in some examples, the disclosed systems may include a sub-system 1860 such as a system on a chip (SOC) or an integrated system of multiple ICs, which is illustrated with respect to mobile computing platform 1805.

Whether disposed within integrated system 1810 illustrated in expanded view 1820 or as a stand-alone packaged device within data server machine 1806, sub-system 1860 may include memory circuitry and/or processor circuitry 1840 (e.g., RAM, a microprocessor, a multi-core microprocessor, graphics processor, etc.), a power management integrated circuit (PMIC) 1830, a controller 1835, and a radio frequency integrated circuit (RFIC) 1825 (e.g., including a wideband RF transmitter and/or receiver (TX/RX)). As shown, one or more IC dies, such as memory circuitry and/or processor circuitry 1840 may be assembled and implemented such that one or more have an IC assembly including a hanging bridge die interposer structure as described herein. In some embodiments, RFIC 1825 includes a digital baseband and an analog front-end module further including a power amplifier on a transmit path and a low noise amplifier on a receive path. Functionally, PMIC 1830 may perform battery power regulation, DC-to-DC conversion, etc., and so has an input coupled to battery 1815, and an output providing a current supply to other functional modules. As further illustrated in FIG. 18, in the exemplary embodiment, RFIC 1825 has an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. Memory circuitry and/or processor circuitry 1840 may provide memory functionality for sub-system 1860, high level control, data processing and the like for sub-system 1860. In alternative implementations, each of the SOC modules may be integrated onto separate ICs coupled to a package substrate, interposer, or board.

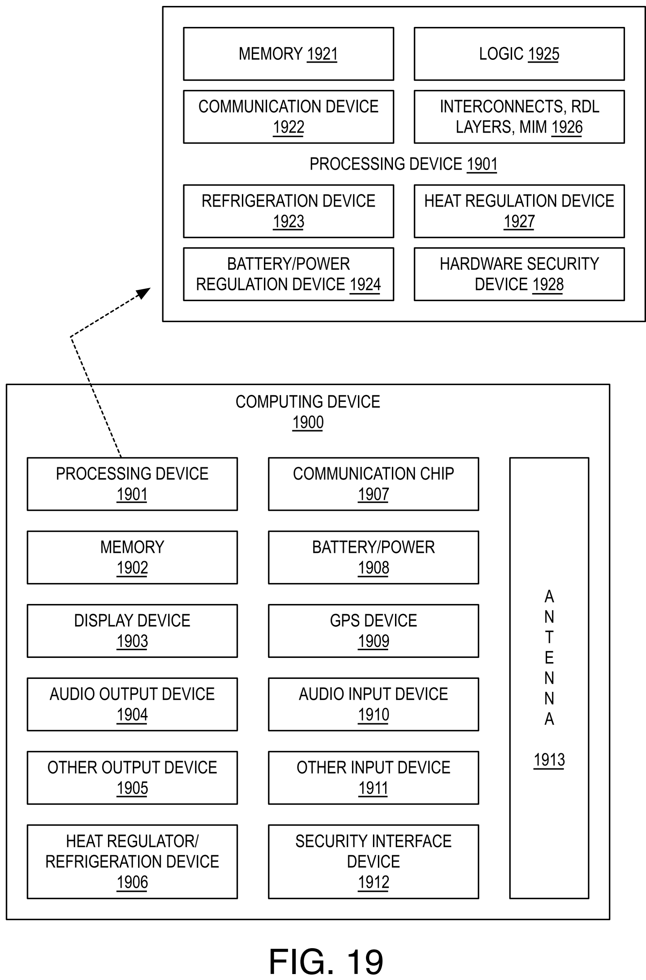

FIG. 19 is a block diagram of a computing device 1900, in accordance with some embodiments. For example, one or more components of computing device 1900 may include any of the package structures or assemblies having a hanging bridge die interposer structure as discussed elsewhere herein. A number of components are illustrated in FIG. 19, but any one or more of these components may be omitted or duplicated, as suitable for the application. In some embodiments, some of the components included in computing device 1900 may be attached to one or more printed circuit boards (e.g., a motherboard). In some embodiments, various ones of these components may be fabricated onto a single system-on-a-chip (SoC) die or implemented with a disintegrated plurality of chiplets or tiles packaged together. Any of such packaged components may include a hanging bridge die interposer structure, for example, as discussed herein. Additionally, in various embodiments, computing device 1900 may not include one or more of the components illustrated in FIG. 19, but computing device 1900 may include interface circuitry for coupling to the one or more components. For example, computing device 1900 may not include a display device 1903, but may include display device interface circuitry (e.g., a connector and driver circuitry) to which display device 1903 may be coupled.

Computing device 1900 may include a processing device 1901 (e.g., one or more processing devices). As used herein, the term processing device or processor indicates a device that processes electronic data from registers and/or memory to transform that electronic data into other electronic data that may be stored in registers and/or memory. Processing device 1901 may include a memory 1921, a communication device 1922, a refrigeration/active cooling device 1923, a battery/power regulation device 1924, logic 1925, interconnects 1926, a heat regulation device 1927, and a hardware security device 1928.

Processing device 1901 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable compute units.

Processing device 1901 may include a memory 1902, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, processing device 1901 shares a package with memory 1902. This memory may be used as cache memory and may include embedded dynamic random-access memory (eDRAM) or spin transfer torque magnetic random-access memory (STT-M RAM).

Computing device 1900 may include a heat regulation/refrigeration device 1906. Heat regulation/refrigeration device 1906 may maintain processing device 1901 (and/or other components of computing device 1900) at a predetermined low temperature during operation. This predetermined low temperature may be any temperature discussed elsewhere herein.

In some embodiments, computing device 1900 may include a communication chip 1907 (e.g., one or more communication chips). For example, the communication chip 1907 may be configured for managing wireless communications for the transfer of data to and from computing device 1900. The term "wireless" and its derivatives may be used to describe circuits, devices, systems, methods, techniques, communications channels, etc., that may communicate data through the use of modulated electromagnetic radiation through a nonsolid medium.

Computing device 1900 may include any photonics structure discussed herein that may facilitate communication between one or more instances of processing device 1901 and/or one or more instances of memory 1902, for example.

Computing device 1900 may include battery/power circuitry 1908. Battery/power circuitry 1908 may include one or more energy storage devices (e.g., batteries or capacitors) and/or circuitry for coupling components of computing device 1900 to an energy source separate from computing device 1900 (e.g., AC line power).

Computing device 1900 may include a display device 1903 (or corresponding interface circuitry, as discussed above). Display device 1903 may include any visual indicators, such as a heads-up display, a computer monitor, a projector, a touchscreen display, a liquid crystal display (LCD), a light-emitting diode display, or a flat panel display, for example.

Computing device 1900 may include an audio output device 1904 (or corresponding interface circuitry, as discussed above). Audio output device 1904 may include any device that generates an audible indicator, such as speakers, headsets, or earbuds, for example.

Computing device 1900 may include an audio input device 1910 (or corresponding interface circuitry, as discussed above). Audio input device 1910 may include any device that generates a signal representative of a sound, such as microphones, microphone arrays, or digital instruments (e.g., instruments having a musical instrument digital interface (MIDI) output).

Computing device 1900 may include a global positioning system (GPS) device 1909 (or corresponding interface circuitry, as discussed above). GPS device 1909 may be in communication with a satellite-based system and may receive a location of computing device 1900, as known in the art.

Computing device 1900 may include another output device 1905 (or corresponding interface circuitry, as discussed above). Examples include an audio codec, a video codec, a printer, a wired or wireless transmitter for providing information to other devices, or an additional storage device.

Computing device 1900 may include another input device 1911 (or corresponding interface circuitry, as discussed above). Examples may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 1900 may include a security interface device 1912. Security interface device 1912 may include any device that provides security measures for computing device 1900 such as intrusion detection, biometric validation, security encode or decode, managing access lists, malware detection, or spyware detection.

Computing device 1900 may include an antenna 1913. Antenna 1913 may include any device that translates electrical current to radio waves and/or translates radio waves to electrical current.

Computing device 1900, or a subset of its components, may have any appropriate form factor, such as a server or other networked computing component, a mobile device, a printer, a scanner, a monitor, a set-top box, an entertainment control unit, a vehicle control unit, a digital camera, a digital video recorder, or a wearable computing device.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

It will be recognized that the invention is not limited to the embodiments so described, but can be practiced with modification and alteration without departing from the scope of the appended claims. For example, the above embodiments may include specific combinations of features as further provided below.

The following pertain to exemplary embodiments.

In one or more first embodiments, an apparatus comprises a bridge die comprising a monolithic substrate and a routing structure on a first surface of the monolithic substrate, and a redistribution structure over the bridge die and extending beyond a perimeter of the bridge die, the redistribution structure comprising a first metallization layer comprising a power mesh metallization over the bridge die and extending beyond the perimeter, a plurality of signal vias extending through the first metallization layer within the perimeter, the signal vias each surrounded by a dielectric material in contact with the signal vias and the power mesh metallization, and a power via extending through the first layer within the perimeter, the power via in contact with the power mesh metallization.

In one or more second embodiments, further to the first embodiments, the power mesh metallization comprises a power supply mesh metallization and the power via comprises a power supply via, and the redistribution structure further comprises a second metallization layer over or under the first metallization layer, the second metallization layer comprising a ground mesh metallization over the bridge die and extending beyond the perimeter, wherein the signal vias extends through the second metallization layer within the perimeter, and wherein the dielectric material or a second dielectric material is in contact with each of the signal vias and the ground mesh metallization.

In one or more third embodiments, further to the first or second embodiments, the redistribution structure further comprises a ground via extending through the first metallization layer within the perimeter, the ground via in contact with the ground mesh metallization, such that the dielectric material is in contact with ground via and the power supply mesh metallization.

In one or more fourth embodiments, further to the first through third embodiments, the bridge die is absent any through substrate vias, and wherein the routing structure interconnects the signal vias within the perimeter.

In one or more fifth embodiments, further to the first through fourth embodiments, the apparatus further comprises a metallization structure coupled to the power mesh metallization and in contact with the redistribution structure outside of the perimeter, the metallization structure extending vertically from the redistribution structure outside of the perimeter to a position below a second surface of the bridge die opposite the first surface.

In one or more sixth embodiments, further to the first through fifth embodiments, the metallization structure comprises a post portion and an interconnect portion, wherein the routing structure is laterally adjacent to the post portion.

In one or more seventh embodiments, further to the first through sixth embodiments, the second surface of the bridge die is absent any signal or power routing structure.

In one or more eighth embodiments, further to the first through seventh embodiments, each of the signal vias has a cross-sectional shape, and wherein the power mesh metallization comprises a substantially conformal cross-sectional shape opening at each of the signal vias.

In one or more ninth embodiments, further to the first through eighth embodiments, the apparatus further comprises a first integrated circuit (IC) die having at least a portion thereof within the perimeter and coupled to a first of the signal vias, and a second IC die having at least a portion thereof within the perimeter and coupled to a second of the signal vias, the first of the signal vias and the second of the signal vias interconnected by the routing structure.

In one or more tenth embodiments, further to the first through ninth embodiments, the apparatus further comprises a package or host substrate coupled opposite the bridge die from the routing structure and coupled to the first metallization layer.

In one or more eleventh embodiments, an apparatus comprises a bridge die comprising a monolithic substrate between a first surface and an opposing second surface, and a routing structure on the first surface, a redistribution structure over the bridge die, the redistribution structure comprising a first metallization layer comprising a power supply mesh metallization over the bridge die and extending beyond a perimeter of the bridge die, a second metallization layer comprising a ground mesh metallization over the bridge die and extending beyond the perimeter, and a plurality of signal vias extending through and insulated from the first metallization layer and the second metallization layer within the perimeter, and a power supply metallization structure and a ground metallization structure each extending vertically from the redistribution structure outside of the perimeter to a position below the second surface of the bridge die.

In one or more twelfth embodiments, further to the eleventh embodiments, the bridge die is absent any through substrate vias, and wherein the routing structure interconnects signal vias within the perimeter.

In one or more thirteenth embodiments, further to the eleventh or twelfth embodiments, the power supply metallization structure comprises a post portion and an interconnect portion, wherein the routing structure is laterally adjacent to the post portion.

In one or more fourteenth embodiments, further to the eleventh through thirteenth embodiments, the second surface of the bridge die is absent any signal or power routing structure.

In one or more fifteenth embodiments, further to the eleventh through fourteenth embodiments, each of the signal vias has a cross-sectional shape, and wherein the power supply mesh metallization and the ground mesh metallization each comprise a substantially conformal cross-sectional shape opening at each of the signal vias.

In one or more sixteenth embodiments, further to the eleventh through fifteenth embodiments, the apparatus further comprises a first integrated circuit (IC) die having at least a portion thereof within the perimeter and coupled to a first of the signal vias, and a second IC die having at least a portion thereof within the perimeter and coupled to a second of the signal vias, the first of the signal vias and the second of the signal vias interconnected by the routing structure.

In one or more seventeenth embodiments, further to the eleventh through sixteenth embodiments, the apparatus further comprises a package or host substrate coupled opposite the bridge die from the routing structure and coupled to the first metallization layer.

In one or more eighteenth embodiments, a method comprises forming a redistribution structure over a carrier, the redistribution structure comprising a metallization mesh surrounding a plurality of metal vias, mounting an integrated circuit (IC) die to the redistribution structure, wherein a first die level interconnect is coupled to a first of the metal vias and a second die level interconnect is coupled to the metallization mesh, removing the redistribution structure from the carrier, and mounting a bridge die comprising a monolithic substrate to the redistribution structure, wherein the first die level interconnect and the second die level interconnect are within a perimeter of the bridge die.

In one or more nineteenth embodiments, further to the eighteenth embodiments, the method further comprises forming a metallization structure on the redistribution structure and laterally adjacent to the bridge die outside of the perimeter, the metallization structure coupled to the metallization mesh.

In one or more twentieth embodiments, further to the eighteenth or twentieth embodiments, the method further comprises coupling the metallization structure to an electronics substrate.

It will be recognized that the invention is not limited to the embodiments so described, but can be practiced with modification and alteration without departing from the scope of the appended claims. For example, the above embodiments may include specific combination of features. However, the above embodiments are not limited in this regard and, in various implementations, the above embodiments may include undertaking only a subset of such features, undertaking a different order of such features, undertaking a different combination of such features, and/or undertaking additional features than those features explicitly listed. The scope of the invention should, therefore, be determined with reference to the appended claims, along with the full scope of equivalents to which such claims are entitled.

## Claims

1. An apparatus, comprising:
a bridge die comprising a monolithic substrate and a routing structure on a first surface of the monolithic substrate; and
a redistribution structure over the bridge die and extending beyond a perimeter of the bridge die, the redistribution structure comprising:
a first metallization layer comprising a power mesh metallization over the bridge die and extending beyond the perimeter;
a plurality of signal vias extending through the first metallization layer within the perimeter, the signal vias each surrounded by a dielectric material in contact with the signal vias and the power mesh metallization; and
a power via extending through the first metallization layer within the perimeter, the power via in contact with the power mesh metallization.

2. The apparatus of claim 1, wherein the power mesh metallization comprises a power supply mesh metallization and the power via comprises a power supply via, the redistribution structure further comprising:
a second metallization layer over or under the first metallization layer, the second metallization layer comprising a ground mesh metallization over the bridge die and extending beyond the perimeter, wherein the signal vias extends through the second metallization layer within the perimeter, and wherein the dielectric material or a second dielectric material is in contact with each of the signal vias and the ground mesh metallization.

3. The apparatus of claim 2, wherein the redistribution structure further comprises:
a ground via extending through the first metallization layer within the perimeter, the ground via in contact with the ground mesh metallization, wherein the dielectric material is in contact with ground via and the power supply mesh metallization.

4. The apparatus of any one of claims 1 to 3, wherein the bridge die is absent any through substrate vias, and wherein the routing structure interconnects the signal vias within the perimeter.

5. The apparatus of any one of claims 1 to 4, further comprising:
a metallization structure coupled to the power mesh metallization and in contact with the redistribution structure outside of the perimeter, the metallization structure extending vertically from the redistribution structure outside of the perimeter to a position below a second surface of the bridge die opposite the first surface.

6. The apparatus of claim 5, wherein the metallization structure comprises a post portion and an interconnect portion, wherein the routing structure is laterally adjacent to the post portion.

7. The apparatus of claim 5 or 6, wherein the second surface of the bridge die is absent any signal or power routing structure.

8. The apparatus of any one of claims 1 to 7, wherein each of the signal vias has a cross-sectional shape, and wherein the power mesh metallization comprises a substantially conformal cross-sectional shape opening at each of the signal vias.

9. The apparatus of any one of claims 1 to 8, further comprising:
a first integrated circuit (IC) die having at least a portion thereof within the perimeter and coupled to a first of the signal vias; and
a second IC die having at least a portion thereof within the perimeter and coupled to a second of the signal vias, the first of the signal vias and the second of the signal vias interconnected by the routing structure.

10. The apparatus of any one of claims 1 to 9, further comprising:
a package or host substrate coupled opposite the bridge die from the routing structure and coupled to the first metallization layer.

11. A method, comprising:
forming a redistribution structure over a carrier, the redistribution structure comprising a metallization mesh surrounding a plurality of metal vias;
mounting an integrated circuit (IC) die to the redistribution structure, wherein a first die level interconnect is coupled to a first of the metal vias and a second die level interconnect is coupled to the metallization mesh;
removing the redistribution structure from the carrier; and
mounting a bridge die comprising a monolithic substrate to the redistribution structure, wherein the first die level interconnect and the second die level interconnect are within a perimeter of the bridge die.

12. The method of claim 11, further comprising:
forming a metallization structure on the redistribution structure and laterally adjacent to the bridge die outside of the perimeter, the metallization structure coupled to the metallization mesh.

13. The method of claim 12, further comprising:
coupling the metallization structure to an electronics substrate.

14. The method of any one of claims 11 to 13, wherein the redistribution structure comprises a plurality of signal vias extending through the metallization mesh, the signal vias each surrounded by a dielectric material in contact with the signal vias and the metallization mesh.

15. The method of any of one claims 11 to 14, wherein the bridge die is absent any through substrate vias.
